(19) Europäisches Patentamt
European Patent Office
Office européen des brevets

(11) **EP 2 696 380 A2**

(12) **EUROPEAN PATENT APPLICATION**

(43) Date of publication:
**12.02.2014 Bulletin 2014/07**

(51) Int Cl.:
***H01L 33/60*** (2010.01)

(21) Application number: **13159297.4**

(22) Date of filing: **14.03.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **07.08.2012 JP 2012174822**
**08.02.2013 JP 2013023258**

(71) Applicant: **Toshiba Lighting & Technology Corporation**
**Yokosuka-shi**
**Kanagawa 237-8510 (JP)**

(72) Inventor: **Honma, Takuya**
**Kanagawa, 237-8510 (JP)**

(74) Representative: **Bokinge, Ole**
**Awapatent AB**
**Junkersgatan 1**
**582 35 Linköping (SE)**

(54) **Light emitting module and lighting system**

(57)   A light emitting module (13) according to embodiments includes a substrate (21). In addition, the light emitting module (13) according to the embodiments includes a light emitting element (29) which is provided on the substrate (21). In addition, the light emitting module (13) according to the embodiments includes a reflecting member (32) which is provided on the substrate (21), formed of a material containing silicon resin, of which Martens hardness of the material is any value in a range of 0.05 (N/mm$^2$) or more and 10.0 (N/mm$^2$) or less, and which reflects light which is emitted from the light emitting element (29).

FIG.4

EP 2 696 380 A2

## Description

FIELD

Embodiments described herein relate generally to a light emitting module and a lighting system.

BACKGROUND

In recent years, a use of a material having high reflectance properties is required in consideration of a light extraction in a light emitting module along with a higher efficiency of an LED (light emitting diode). In particular, a portion of a resist of the light emitting module plays an important role in the light extraction. Therefore, a technology is present in which ceramics such as $Al_2O_3$ having a relatively high reflectivity are dispersed in an organic solvent, and are applied onto a substrate, and a baked inorganic ceramic coating material is used in the portion of the resist.

Meanwhile, loads of heat and light on a member which configures a light emitting module also become large. In addition, along with this, deterioration in the member due to the heat and light easily occurs. The deterioration in the member leads to a decrease in a lumen maintenance factor of light which is output from a light emitting module. For example, there is a concern that a crack may occur in the ceramic coating material when a substrate is expanded due to heat. In addition, when the crack occurs in the ceramic coating material, reflectance properties are decreased. In addition, the ceramic coating material has low adhesion with other members. For this reason, the ceramic coating material has low versatility.

Therefore, using a member which is formed of a material containing silicon resin in the portion of the resist is also taken into consideration. However, when merely using the member which is formed of the material containing silicon resin in the portion of the resist, since the member is hard, there is a concern that a crack may occur in the member when the substrate is expanded due to heat from a light emitting module, or the like. For this reason, there is a problem in that a light emitting module, and a lighting system which includes the light emitting module lack in reliability, when merely using the member which is formed of the material containing silicon resin in the portion of the resist.

An object of exemplary embodiments is to provide a light emitting module and a lighting system with high reliability.

DESCRIPTION OF THE DRAWINGS

FIG. 1 is a diagram which illustrates an example of a light emitting module according to a first embodiment.

FIG. 2 is a diagram which illustrates an example of a light emitting module according to the first embodiment.

FIG. 3 is a diagram which illustrates an example of a light emitting module according to the first embodiment.

FIG. 4 is a diagram which illustrates an example of a lighting system.

FIG. 5 is a diagram which illustrates an example of a method of measuring Martens hardness, a creep rate, and elastic modulus.

FIG. 6 is a diagram which illustrates a light emitting module according to a second embodiment.

FIG. 7 is a diagram which describes a resist layer according to the second embodiment.

DETAILED DESCRIPTION

Hereinafter, a light emitting module and a lighting system according to each embodiment will be described with reference to drawings. Configurations having the same function in each embodiment are given the same reference numerals, and repeated descriptions will be omitted. In addition, a light emitting module and a lighting system which will be described in the following embodiments are merely examples, and do not limit the exemplary embodiments. In addition, embodiments below may be appropriately combined as long as it is not contradictive.

In first and second embodiments below, a light emitting module includes a substrate. In addition, in the first and second embodiments, the light emitting module includes a light emitting element which is provided on the substrate. Further, in the first and second embodiments, the light emitting module includes a reflecting member which is provided on the substrate, is formed of a material containing silicon resin, of which Martens hardness of the material is any value in a range of 0.05 (N/mm$^2$) or more and 10.0 (N/mm$^2$) or less, and reflects light which is emitted from a light emitting element. The reflecting member which is formed of the material containing silicon resin, and of which Martens hardness of the material is any value in the range of 0.05 (N/mm$^2$) or more and 10.0 (N/mm$^2$) or less is soft compared to a material which contains silicon resin of which Martens hardness is larger than 10.0 (N/mm$^2$). For this reason, in the reflecting member according to the first and second embodiments, a crack or the like hardly occurs even when a substrate is expanded due to heat of a light emitting element. Accordingly, in the light emitting module and lighting system according to the first and second embodiments which include the reflecting member, it is possible to obtain high reliability.

In addition, in the first and second embodiments below, elastic energy of a material which forms the reflecting member is any value in a range of 1.0 (N·mm) or more and 10.0 (N·mm) or less. A reflecting member of which the elastic energy of the material is any value in a range of 1.0 (N·mm) or more and 10.0 (N·mm) or less is soft compared to a material containing silicon resin of which elastic energy is larger than 10.0 (N·mm). For this reason, in the reflecting member according to the first and second embodiments, a crack or the like hardly occurs even when a substrate is expanded due to heat of a light emitting element. Accordingly, in the light emitting module and lighting system according to the first and second embodiments which include the reflecting member, it is possible to obtain high reliability.

In addition, in the first and second embodiments below, a creep rate of a material which forms the reflecting member is any value in a range of 1.0 (%) or more and 10.0 (%) or less. A reflecting member of which the creep rate of the material is any value in the range of 1.0 (%) or more and 10.0 (%) or less is soft compared to a material containing silicon resin of which the creep rate is larger than 10.0 (%). For this reason, in the reflecting member according to the first and second embodiments, a crack or the like hardly occurs even when a substrate is expanded due to heat of the light emitting element. Accordingly, in the light emitting module and lighting system according to the first and second embodiments which include the reflecting member, it is possible to obtain high reliability.

In addition, a light emitting module in each embodiment in the following first and second embodiments includes a plated member which is provided between a substrate and a reflecting member, and is plated. In addition, the light emitting module according to each of the first and second embodiments below includes an adhering member which is provided between the plated member and the reflecting member, is formed of a material containing epoxy resin, and bonds the plated member and the reflecting member. A material containing epoxy resin has high adhesion of bonding the plated member and the reflecting member to each other. For this reason, it is possible to prevent the reflecting member from being separated from the plated member. Accordingly, it is possible to obtain high reliability when using the light emitting module in each embodiment of the first and second embodiments.

In addition, the light emitting module in each embodiment of the first and second embodiments includes a lens which adheres to a surface of a reflecting member which is on an opposite side to the substrate side, and is formed of a material containing silicon resin. A reflecting member having Martens hardness, elastic energy, or creep rate in the above described range is soft, as described above. For this reason, the lens strongly adheres to the reflecting member, and is hardly separated. Accordingly, it is possible to obtain high reliability when using the light emitting module in each embodiment of the first and second embodiments.

In addition, thickness of the reflecting member in the first and second embodiments which will be described below is any value in a range of 2 $\mu$m or more and 100 $\mu$m or less.

In addition, as a material of the reflecting member according to the first and second embodiments below, at least one material of titanium oxide ($TiO_2$), alumina ($Al_2O_3$), and silica ($SiO_2$) is contained.

In addition, a lighting system according to the first and second embodiments below includes a light emitting module, and a lighting device which supplies power to the light emitting module. A lighting system including the above described light emitting module can obtain high reliability due to the same reason as the above described reason.

In addition, the reflecting member according to the second embodiment below is provided so that at least a part of an end portion of an adhering member is not exposed to the outside. In this manner, it is possible to prevent the adhering member which is formed of a material containing epoxy, which is easily deteriorated by heat and light from being exposed to the atmosphere. As a result, the adhering member hardly deteriorates. Accordingly, a light emitting module including the reflecting member according to the second embodiment can obtain higher reliability.

In addition, in the second embodiment below, thickness of the reflecting member at a portion which is positioned in the middle of a distance from the plated member to the substrate is a half is 2 $\mu$m or more and 5 $\mu$m or less.

In addition, in the first and second embodiments below, as a light emitting element of a semiconductor, it is possible to adopt an LED chip, however, it is not limited to this. For example, it is also possible to use a semiconductor laser, or an EL (electro-luminescence) element. When the LED chip is used in the light emitting element, luminous color of the LED chip may be any of red, green, and blue. In addition, it may be also possible to use an LED chip of different colors by combining thereof.

First Embodiment

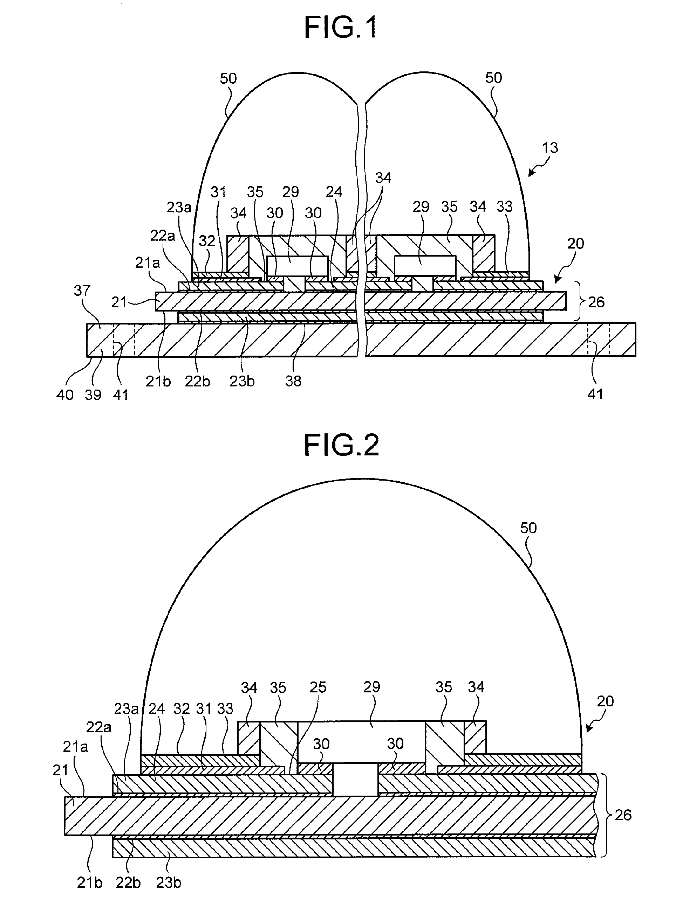

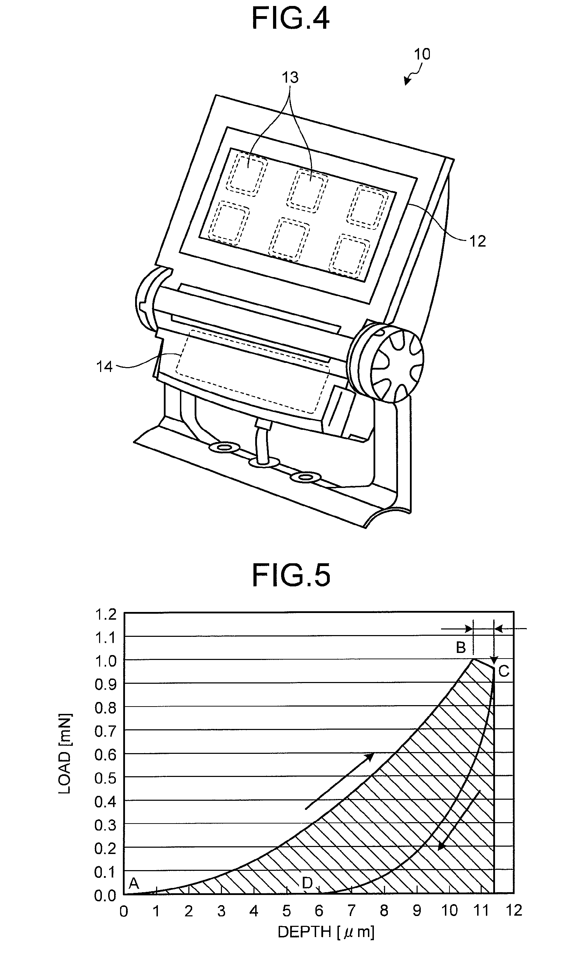

First embodiment will be described with reference to FIGS. 1 to 4. FIG. 4 is a diagram which illustrates an example of a lighting system. A lighting system 10 is illustrated in FIG. 4. The lighting system 10 is, for example, floodlights which are used for lighting up an area. The lighting system 10 includes a system main body 11. A light projection window 12 is provided in the system main body 11. A plurality of light emitting modules 13 which face the light projection window 12 are accommodated in the system main body 11. A lighting device 14 which supplies lighting power to the light emitting module 13 is accommodated at the lower portion in the system main body 11. In addition, when the lighting device 14 supplies lighting power to the plurality of light emitting modules 13, the plurality of light emitting modules 13 are lit up, and light is radiated from the light projection window 12.

FIGS. 1 to 3 are diagrams which illustrate an example according to the first embodiment. The light emitting module 13 according to the first embodiment is illustrated in FIGS. 1 to 3. The light emitting module 13 includes a wiring board unit 20.

The wiring board unit 20 includes a rectangular ceramic substrate 21. Hereinafter, the ceramic substrate 21 is simply referred to as a substrate 21. The front surface side of the substrate 21 is a first surface 21a. The rear surface side of the substrate 21 is a second surface 21b. A first electrode layer 22a is formed on the first surface 21a. A first copper plated layer 23a is formed on the first electrode layer 22a. By the first electrode layer 22a and the first copper plated layer 23a, a wiring pattern 24 of a predetermined shape is formed. On the other hand, the second electrode layer 22b is formed on the approximately entire region of the second surface 21b. A second copper plated layer 23b is formed on the second electrode layer 22b. In addition, on the surfaces of the copper plated layers 23a and 23b, a metal plated layer 25 which protects the copper plated layers 23a and 23b is formed.

The electrode layers 22a and 22b are formed through sputtering of metal such as titanium. The copper plated layers 23a and 23b are formed through copper plating processing. In addition, the metal plated layer 25 is formed through nickel-gold plating processing, or nickel-lead-gold plating processing. The DPC (Direct Plated Copper) substrate 26 is formed of the substrate 21, the electrode layers 22a and 22b, the copper plated layers 23a and 23b, and the metal plated layer 25.

The first electrode layer 22a and the second electrode layer 22b are formed to have the same thickness. In addition, the first copper plated layer 23a and the second copper plated layer 23b are formed to have the same thickness.

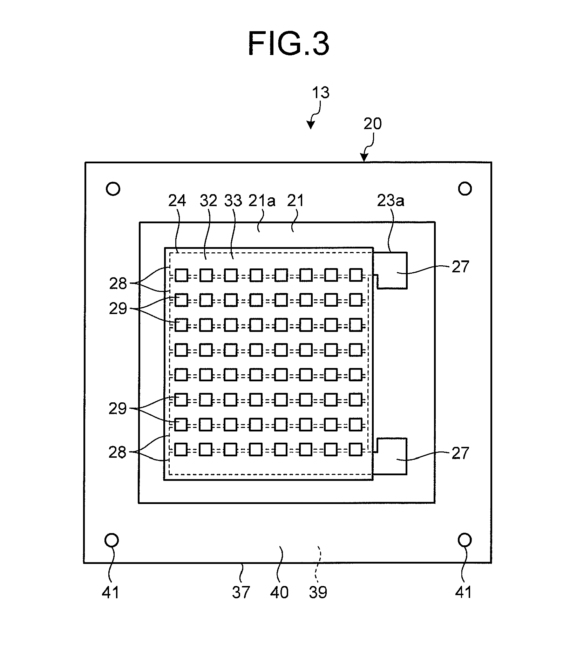

As illustrated in FIG. 3, the wiring pattern 24 includes a pair of electrode units 27 which receive a supply of lighting power from the outside. A plurality of wiring units 28 are formed in parallel between the pair of electrode units 27. In addition, a plurality of LED elements 29 are mounted on the neighboring wiring units 28.

As illustrated in FIG. 1, in the plurality of LED elements 29, for example, a type which has a pair of electrodes on the rear surface side such as a flip chip type is used. The pair of electrodes of the plurality of LED elements 29 are configured to be electrically connected to the first copper plated layer 23a by a solder die-attach layer 30. In addition, in the LED element 29, like a face-up type, the electrodes of the LED element 29 may be connected to the wiring pattern 24 using wire bonding by including the electrodes on the front surface side.

As illustrated in FIG. 2, a base layer 31 is formed on the first surface 21a side including the first copper plated layer 23a. The base layer 31 is formed of a material including an organic material such as epoxy resin. The base layer 31 is configured to be provided between the first copper plated layer 23a and a resist layer 32 which will be described later, and attaches the first copper plated layer 23a to the resist layer 32 which will be described later. Though it is described later, the resist layer 32 is formed of a material including silicon resin. For this reason, by causing the resist layer 32 which is formed of such a material and the first copper plated layer 23a to adhere to each other using the base layer 31, the adherence between the resist layer 32 and the first copper plated layer 23a is improved. In this manner, since the adherence between the resist layer 32 and the first copper plated layer 23a is improved using the base layer 31, it is possible to obtain high reliability of the light emitting module 13.

The resist layer 32 is formed on the base layer 31. The surface of the resist layer 32 is formed as a reflecting surface 33 which reflects light beams which are output from the plurality of LED elements 29.

The resist layer 32 is formed of a material including silicon resin. In addition, as a material of the resist layer 32, a material of which a value of the Martens hardness is any value in a range of 0.05 (N/mm$^2$) or more and 10.0 (N/mm$^2$) or less is used. In addition, as a material of the resist layer 32, a material of which a value of the elastic energy is any value in a range of 1.0 (N·mm) or more and 10.0 (N·mm) or less is used. In addition, as a material of the resist layer 32, a material of which a creep rate is any value in a range of 1.0 (%) or more and 10.0 (%) or less is used.

In addition, details of the Martens hardness, the elastic energy, and the creep rate will be described later.

<Martens hardness>

The Martens hardness is a physical property which is obtained from a measuring method which is defined in ISO14577-1 Metallic materials- Instrumented indentation test for hardness and materials parameters Part I: Test method. In addition, the physical property is calculated using a load, and the indentation depth thereof.

<Creep rate>

The creep rate (also referred to as indentation creep rate) is a rate of variability of the depth (the hollow depth) when a load is set to be constant for a predetermined time, and when the creep rate is represented by C, it is expressed in Expression (1).

$$C=((h2-h1)/h1)*100 \quad (1)$$

h1 in the Expression (1) is the depth when reaching a load in a setting examination test, and h2 is the depth when maintaining the load in the setting examination test.

<Elastic modulus>

The elastic modulus is a physical property denoting a difficulty in deformation, and a proportional constant between stress and distortions in an elastic change.

For example, it is possible to measure Martens hardness, a creep rate, and an elastic modulus from a relationship diagram between a depth and a load as illustrated in FIG. 5 which is obtained from a measurement result in which a diamond indenter of a trigonal pyramid of which a tip end angle is 120° is indented to a sample, and the depth thereof is measured.

Here, the depth which is denoted by the point B in the example in FIG. 5 corresponds to the h1 in Expression (1), and the depth which is denoted by the point C corresponds to h2 in Expression (1). In addition, in the example in FIG. 5, the elastic modulus is denoted by a ratio of the depth which is denoted by the point C to the depth which is dented by the point D, that is, a slope of a line segment connecting the point C and the point D.

In addition, in FIG. 5, the deformation from the point A to the point B is plastic deformation. In addition, in FIG. 5, the deformation from the point C to the point D is elastic deformation.

The ranges of the Martens hardness, the elastic energy, and the creep rate of materials which form the resist layer 32 are ranges in which a crack does not occur even when there is a thermal expansion of the substrate which is obtained as a result of a predetermined test, and are ranges in which the lens which adheres to the resist layer is hardly separated from the resist layer. The test will be described. In the test, a time until a crack occurs in the resist layer, and a time until the lens is separated from the resist layer are obtained using a light emitting module in which values of Martens hardness, an elastic energy, and a creep rate of a material including silicon resin which forms the resist layer are different. In the test, it is found that in a light emitting module in which a time until a crack occurs on a resist layer is long, it takes a long time until a lens is separated from the resist layer, and it is found that there is a correlation between the time until a crack occurs on the resist layer and the time the lens is separated from the resist layer. In addition, in the test, it is found that, for example, between a material of which a value in the creep rate is any value in a range of 1.0 (%) or more and 10.0 (%) or less and a material of which the value in the creep rate is larger than 10.0 (%), the time until a crack occurs in the resist layer, and the time until the lens is separated from the resist layer in the former material are much longer than those of the latter material. In addition, it is found that between a material of which a value in the Martens hardness is any value in a range of 0.05 (N/mm$^2$) or more and 10.0 (N/mm$^2$) or less and a material of which the value in the Martens hardness is not included in the range, the time until a crack occurs in the resist layer, and the time until the lens is separated from the resist layer in the former material are longer than those of the latter material, as well. Further, it is found that between a material of which a value in the elastic energy is any value in a range of 1.0 (N·mm) or more and 10.0 (N·mm) or less and a material of which the value in the elastic energy is not included in the range, the time until a crack occurs in the resist layer, and the time until the lens is separated from the resist layer in the former material are longer than those of the latter material, as well.

The thickness of the resist layer 32 may be any value in a range of 2 μm or more and 100 μm or less. In addition, in the material of the resist layer 32, at least one material of titanium oxide (TiO$_2$), alumina (Al$_2$O$_3$), and silica (SiO$_2$) may be included.

In addition, a circular reflecting frame 34 is provided on the first surface 21a side and configured to surround the plurality of LED elements 29, respectively. Sealing resin 35 which seals the LED elements 29 is filled in the reflecting frame 34. The sealing resin 35 contains phosphor which is excited by light which is generated in the LED elements 29. For example, when the light emitting module 13 radiates white light, LED element 29 of blue light, and phosphor of which the main component is yellow are used. The blue light which is generated in the LED element 29 and yellow light which is generated in the phosphor which is excited by the blue light which is generated in the LED element 29 are mixed, thereby radiating the white light from the surface of the sealing resin 35. In addition, according to light color which is irradiated, an LED element 29 and phosphor of a corresponding color are used.

In addition, a heat spreader 37 is fixed to the second copper plated layer 23b through a solder layer 38. The heat spreader 37 is thermally connected to the second copper plated layer 23b. The heat spreader 37 includes a copper plate 39 of which the plate thickness is 0.1 mm to 3 mm. In the entire surface of the copper plate 39, for example, a metal plated layer 40 such as nickel plated layer is formed. Attaching holes 41 for fixing the heat spreader to a radiating unit of the lighting system 10 using screws are formed at four corners of the heat spreader 37.

In addition, the lens 50 is formed of a material including silicon resin. The lens 50 is adhered to the surface of the resist layer 32 which is on the opposite side to the substrate 21 side. The resist layer 32 is formed of a material including silicon resin. Here, an adhesive strength between silicon of which values of Martens hardness, an elastic energy, a creep rate, and the like are not defined in the above described range is weak, however, by setting properties of a material of the resist layer 32 to values in the above described range, adhering stress when coating the lens 50 on the resist layer 32 is relaxed. As a result, the adhesive strength between the resist layer 32 and the lens 50 is increased. For this reason, the reliability of the light emitting module 13 is improved.

The above described light emitting module 13 is used by being provided in the system main body 11 as follows. For example, as illustrated in previous FIG. 4, the plurality of light emitting modules 13 are arranged in the system main body 11. In this case, the light emitting modules are fixed to the radiating unit of the system main body 11 by driving screws into the attaching holes 41 of the heat spreader 37. In addition, the heat spreader 37 is thermally connected to the radiating unit of the system main body 11. In addition, the pair of electrode units 27 of the wiring pattern 24, and the lighting device 14 are electrically connected using a power line.

In addition, since lighting power flows in the plurality of LED elements 29 through the wiring pattern 24 of each light emitting module 13 by supplying the lighting power to the plurality of light emitting modules 13 from the lighting device 14, the plurality of light emitting modules 13 are lit up, and light from the plurality of light emitting modules 13 is radiated from the light projection window 12.

Heat which is generated from the plurality of LED elements 29 when the light emitting modules 13 are lit up is efficiently conducted to the first copper plated layer 23a, the substrate 21, the second copper plated layer 23b, and the heat spreader 37. Further, the heat is efficiently conducted to the radiating unit of the system main body 11 from the heat spreader 37, and is radiated from the radiating unit of the system main body 11.

As described above, the first embodiment was described. The light emitting module 13 according to the first embodiment includes the substrate 21. In addition, the light emitting module 13 according to the first embodiment includes the light emitting element (for example, LED element 29) which is provided on the substrate 21. Further, the light emitting module 13 according to the first embodiment includes the reflecting member (for example, resist layer 32) which is provided on the substrate 21, formed of the material containing silicon resin, of which the Martens hardness is in any value in the range of 0.05 (N/mm$^2$) or more and 10.0 (N/mm$^2$) or less, and which reflects light which is emitted from the light emitting element. The reflecting member which is formed of the material containing silicon resin, and of which the Martens hardness is any value in the range of 0.05 (N/mm$^2$) or more and 10.0 (N/mm$^2$) or less is softer than a material containing silicon resin of which Martens hardness is larger than 10.0 (N/mm$^2$). For this reason, in the reflecting member according to the first embodiment, a crack or the like hardly occurs even when the substrate 21 is expanded due to heat from the light emitting element. Accordingly, in the light emitting module 13 and the lighting system 10 according to the first embodiment including the reflecting member, it is possible to obtain high reliability.

In addition, the elastic energy of the material which forms the reflecting member according to the first embodiment (for example, resist layer 32) is any value in the range of 1.0 (N·mm) or more and 10.0 (N·mm) or less. The reflecting member of which the elastic energy is any value in the range of 1.0 (N·mm) or more and 10.0 (N·mm) or less is softer than a material containing silicon resin of which the elastic energy is larger than 10.0 (N·mm). For this reason, in the reflecting member according to the first embodiment, a crack or the like hardly occurs even when the substrate 21 is expanded due to heat from the light emitting element (for example, LED element 29). Accordingly, in the light emitting module 13 and the lighting system 10 according to the first embodiment including the reflecting member, it is possible to obtain high reliability.

In addition, the creep rate of the material which forms the reflecting member according to the first embodiment (for example, resist layer 32) is any value in the range of 1.0 (%) or more and 10.0 (%) or less. The reflecting member of which the creep rate is any value in the range of 1.0 (%) or more and 10.0 (%) or less is softer than a material containing silicon resin of which the creep rate is larger than 10.0 (%). For this reason, in the reflecting member according to the first embodiment, a crack or the like hardly occurs even when the substrate 21 is expanded due to heat from the light emitting element (for example, LED element 29). Accordingly, in the light emitting module 13 and the lighting system 10 according to the first embodiment including the reflecting member, it is possible to obtain high reliability.

In addition, the light emitting module 13 according to the first embodiment includes a plated member (for example, first copper plated layer 23a) which is configured to be between the substrate 21 and the reflecting member (for example, resist layer 32). In addition, the light emitting module 13 according to the first embodiment includes the adhering member (for example, base layer 31) which is provided between the plated member and the reflecting member, formed of the material containing epoxy resin, and which bonds the plated member to the reflecting member. The material containing epoxy resin has high adhesion of bonding the plated member to the reflecting member. For this reason, it is possible to prevent the reflecting member from being separated from the plated member. Accordingly, in the light emitting module 13 and the lighting system 10 according to the first embodiment, it is possible to obtain high reliability.

In addition, the light emitting module 13 according to the first embodiment includes the lens 50 which adheres to the surface of the reflecting member (for example, resist layer 32) which is on the opposite side to the substrate 21 side, and is formed of the material containing silicon resin. As described above, the reflecting member of which the Martens hardness, the elastic energy, or the creep rate is in the above described range is soft. For this reason, the lens 50 strongly adheres to the reflecting member, and is hardly separated from the reflecting member. Accordingly, in the light emitting module 13 and the lighting system 10 according to the first embodiment, it is possible to obtain high reliability.

In addition, the thickness of the reflecting member (for example, resist layer 32) according to the first embodiment is any value in the range of 10 $\mu$m or more and 100 $\mu$m or less. In addition, in the material of the reflecting member according to the first embodiment, at least one material of titanium oxide (TiO$_2$), alumina (Al$_2$O$_3$), and silica (SiO$_2$) is included.

Second Embodiment

Subsequently, a second embodiment will be described. A difference from the above described first embodiment is that a resist layer 32 covers a base layer 31 so that at least a part of an end portion of the base layer 31 is not exposed to the outside. Since points other than that are the same as those in the first embodiment, descriptions thereof will be omitted.

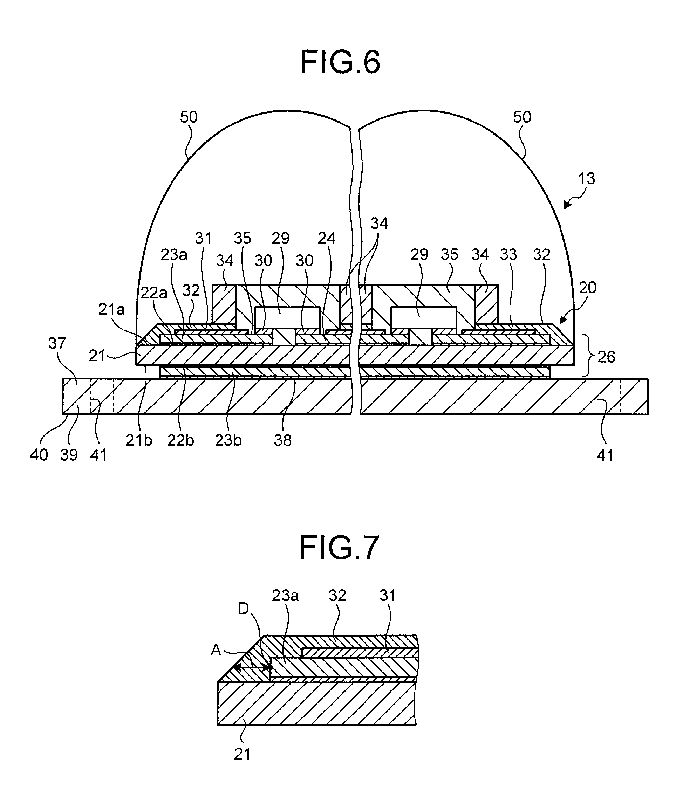

FIG. 6 is a diagram which illustrates a light emitting module according to the second embodiment. Epoxy or the like which is included in a material which forms the base layer 31 easily deteriorates due to heat, and light. Therefore, as illustrated in FIG. 6, the resist layer 32 is provided so that at least a part of the end portion of the base layer 31 is not to be exposed to the outside. In this manner, it is possible to prevent the base layer 31 from being exposed to the atmosphere. For this reason, the base layer 31 hardly deteriorates. Accordingly, a light emitting module 13 and a lighting system 10 which include the resist layer 32 according to the second embodiment can obtain higher reliability.

FIG. 7 is a diagram which describes the resist layer according to the second embodiment. As illustrated in FIG. 7, it is preferable that the thickness A of the resist layer 32 at the portion D which is positioned in the middle of a distance from the opposite surface to a substrate 21 side of a first copper plated layer 23a to the substrate 21 is a value of 2 $\mu$m or more and 5 mm or less.

The second embodiment was described as above. It is possible to obtain the same effects as those in the first embodiment in the second embodiment. In addition to this, in the reflecting member (for example, resist layer 32) according to the second embodiment, at least a part of the end portion of the adhering member (for example, base layer 31) is provided so as not to be exposed to the outside. In this manner, it is possible to prevent the adhering member which is formed of the material containing epoxy which is easily deteriorated by heat and light from being exposed to the atmosphere. As a result, the adhering member hardly deteriorates. Accordingly, the light emitting module 13 and the lighting system 10 which include the reflecting member according to the second embodiment can obtain higher reliability.

In addition, in the second embodiment, the thickness of the reflecting member at the portion D which is positioned in the middle of a distance from the plated member (for example, first copper plated layer 23a) to the substrate 21 is 2 $\mu$m or more and 5 mm or less.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A light emitting module (13) comprising:

   a substrate (21);
   a light emitting element (29) which is provided on the substrate (21);
   a reflecting member (32) which is provided on the substrate (21), formed of a material containing silicon resin, of which Martens hardness of the material is any value in a range of 0.05 (N/mm$^2$) or more and 10.0 (N/mm$^2$) or less, and which reflects light which is emitted from the light emitting element (29).

2. The light emitting module (13) according to claim 1, wherein an elastic energy of the material which forms the reflecting member (32) is any value in a range of 1.0 (N·mm) or more and 10.0 (N·mm) or less.

3. The light emitting module (13) according to claim 1 or 2,
   wherein a creep rate of the material which forms the reflecting member (32) is any value in a range of 1.0 (%) or more and 10.0 (%) or less.

4. The light emitting module (13) according to any one of claims 1 to 3, further comprising:

   a plated member (23a) which is provided between the substrate (21) and the reflecting member (32), and is plated; and
   an adhering member (31) which is provided between the plated member (23a) and the reflecting member (32), is formed of a material containing epoxy resin, and bonds the plated member (23a) to the reflecting member (32).

5. The light emitting module (13) according to claim 4, wherein the reflecting member (32) is provided so that at least a part of an end portion of the adhering member (31) is not exposed to an outside.

6. The light emitting module (13) according to any one of claims 1 to 5, further comprising:

   a lens (50) which adheres to a surface of the reflecting member (32) which is on an opposite side to the substrate (21) side, and is formed of a material containing silicon resin.

7. The light emitting module (13) according to any one of claims 1 to 6,
   wherein thickness of the reflecting member (32) is any value in a range of 2 $\mu$m or more and 100 $\mu$m or less.

8. The light emitting module (13) according to any one of claims 1 to 7,
wherein a material of the reflecting member (32) contains at least one material of titanium oxide, alumina, and silica.

9. The light emitting module (13) according to claim 5, wherein the thickness of the reflecting member (32) at a portion which is positioned in the middle of a distance from the plated member (23a) to the substrate (21) is a half is 2 $\mu$m or more and 5 mm or less.

10. A lighting system (10) comprising:

the light emitting module (13) according to any one of claims 1 to 9; and
a lighting device (14) which supplies power to the light emitting module.

11. The lighting system according to claim 10, wherein the lighting system (10) is floodlights which are used for lighting up an area.

# FIG.1

# FIG.2

# FIG.3

# FIG.4

# FIG.5

# FIG.6

# FIG.7